# EUROPEAN PATENT APPLICATION

(11) **EP 4 819 379 A1**
(43) Date of publication of application: **07.10.2026**
(21) Application number: 26167001.2
(22) Date of filing: 24.03.2026
(51) Int. Cl.: H01P 5/10

(54) **VERTICAL BALUN FOR DIFFERENTIAL-TO-SINGLE ENDED TRANSITION OF MM-WAVE SIGNALS**

(30) Priority: 01.04.2025 US 202519096987
(71) Applicant: NXP B.V., 5656 AG Eindhoven (NL)
(72) Inventor: Syeda, Rabia, 5656AG Eindhoven (NL); Sprenger, Gina Sophia Catharina, 5656AG Eindhoven (NL); de Graauw, Antonius Johannes Matheus, 5656AG Eindhoven (NL)
(74) Representative: Schwarzweller, Thomas

(57) **Abstract**

A multi-level panel level package substrate is formed with a compact vertical balun for converting between single-ended and differential-ended signals, where the vertical balun includes a first non-phase-shifting conductive balun path element having one or more vertically aligned conductive structures formed in at least two package layers and connected between a first differential-ended signal balun node and a single-ended signal balun node; a second phase-shifting conductive balun path element having a plurality of conductive structures formed in at least two package layers and connected between a second differential-ended signal balun node and the single-ended signal balun node; and a single-ended contact element integrally formed with the single-ended signal balun node at a package layer location where the first non-phase-shifting conductive balun path element is directly, electrically connected to the second phase-shifting conductive balun path element.

## Description

### BACKGROUND OF THE INVENTION

### Field of the Invention

The present disclosure is directed in general to the field of integrated circuit devices. In one aspect, the present disclosure relates to a packaged integrated circuit assembly with built-in baluns.

### Description of the Related Art

Modern integrated circuits (ICs) increasingly have complexity, miniaturization, and cost constraints with integrating diverse circuit components and devices into a single packaged assembly. For example, automotive radar chips now include complex RF front end circuits which are integrated with digital circuitry on a shared semiconductor substrate. At the same time, there is demand for miniaturizing the radar systems in autonomous driving and ADAS (advanced driver assistance system) applications. The competing demands between increasing complexity and miniaturization create challenges with routing many signals and ground paths in the radar chip's package while minimizing the chip size as small as possible. A cost-effective and performance-driven packaging technique to connect monolithic microwave integrated circuits (MMIC) input/output (IO) signals to the printed circuit board (PCB) can be realized by using a ball-grid-array (BGA) based package structure. Examples of these packages are embedded wafer level ball grid array (eWLB), flip-chip chip-scale package (FCCSP) and flip-chip ball-grid array (FCBGA). In such packaged assembly solutions, a galvanic connection from the MMIC silicon die to the PCB board is typically used, where the galvanic connection includes two intermediate transitions. In a first die-to-package transition, the die is connected to the package substrate laminates or to a metallization layer on top of a dielectric layer of the package substrate. In the die, a differential signal implementation of the silicon circuitry is often used in order to decrease the sensitivity of the active circuitry to external common-mode signals present, for example, on the PCB lines or traces on a package laminate. As a consequence of the differential signal circuit implementation, the first die-to-package transition will be differential as well. In a second package-to-PCB interface transition, the package is connected to the PCB using the solder-ball ball-grid array using an interface that can be either differential or single-ended. In applications where the PCB uses single-ended connections to, for example, feed single-ended antennas, the package will include a balun circuit component to convert from differential-to-single ended signals, but conventional planar balun components are quite bulky and expensive, adding to the package size and costs.

As seen from the foregoing, existing designs and fabrication processes for IC package assemblies have not provided the cost, size, and electrical performance required for leading-edge integrated circuit assembly packages. Further limitations and disadvantages of conventional processes and technologies will become apparent to one of skill in the art after reviewing the remainder of the present application with reference to the drawings and detailed description which follow.

### BRIEF DESCRIPTION OF THE DRAWINGS

The present invention may be understood, and its numerous objects, features and advantages obtained, when the following detailed description of a preferred embodiment is considered in conjunction with the following drawings.
Figures 1A-1B show cross-sectional and plan views of an encapsulated die attached with a package to a PCB where the package includes a conventional planar balun.
Figure 2 shows a perspective view of a vertical balun in accordance with selected embodiments of the present disclosure.
Figures 3A-3B show cross-sectional and plan views of an encapsulated die attached to a package in which a vertical balun in accordance with selected embodiments of the present disclosure.
Figure 4 illustrates cross-sectional views for a fabrication sequence for forming a package with an integrated vertical balun in accordance with selected embodiments of the present disclosure.
Figure 5 illustrates the simulated RF performance of a vertical balun in accordance with selected embodiments of the present disclosure.

### DETAILED DESCRIPTION

A vertical balun device in a package substrate for converting differential-ended die signals to a single-ended signal and associated method of fabrication are described wherein package conductor layers are sequentially formed or stacked in at least two package layers to define a compact vertical balun which uses less area than a conventional horizontal balun design. In selected embodiments, the vertical balun device is formed in a multi-layer panel level package (PLP) and connected between first and second differential-ended signal nodes (formed in a first layer of the multi-layer package) and a single-ended signal node (formed in a second layer of the multi-layer package). As disclosed, the vertical balun device includes a first non-phase-shifting conductive balun element (connected between the first differential-ended signal node and the single-ended signal node) and a second phase-shifting conductive balun element (connected between the second differential-ended signal node and the single-ended signal node). In particular, the first non-phase-shifting conductive balun element is formed with one or more vertically stacked conductive layers which extend through the multi-layer package to directly electronically connect the first differential-ended signal node and the single-ended signal node. In addition, the second phase-shifting conductive balun element is formed with first and second conductive elements which are aligned in parallel and extend through the multi-layer package to directly electronically connect the second differential-ended signal node and the single-ended signal node. In a first package layer, the first conductive element is spaced apart from the one or more vertically stacked conductive layers and extends laterally a first extension distance to a distal end. In a second package layer, the second conductive element is formed in alignment with the first conductive element and extends laterally a second extension distance from a distal end to make direct electrical contact with the one or more vertically stacked conductive layers. In addition, the vertical balun device may include a first via conductor element which connects the distal ends of the first and second conductive elements. By controlling the combined length of the first and second extension distances to equal one half of the electrical wavelength of the signal frequency of the differential-ended die signal, the path difference for input signal transmitted across the second phase-shifting conductive balun element will transform the input differential-ended signal into a single-ended signal at the single-ended signal node.

In this disclosure, a package substrate and method of manufacture are described for forming an improved vertical balun structure which is formed in first and second metal substrate layers with the winding orientated vertically so as to convert differential ended (DE) signals from an IC die to single ended (SE) signal for output at the package substrate to address various problems in the art where various limitations and disadvantages of conventional solutions and technologies will become apparent to one of skill in the art after reviewing the remainder of the present application with reference to the drawings and detailed description provided herein. Various illustrative embodiments of the present invention will now be described in detail with reference to the accompanying figures. While various details are set forth in the following description, it will be appreciated that the present invention may be practiced without these specific details, and that numerous implementation-specific decisions may be made to the invention described herein to achieve the device designer's specific goals, such as compliance with process-technology requirements or design-related constraints, which will vary from one implementation to another. While such a development effort might be complex and time-consuming, it would nevertheless be a routine undertaking for those of ordinary skill in the art having the benefit of this disclosure. For example, selected aspects are depicted with reference to simplified cross-sectional and plan drawings of a package substrate without including every device feature or geometry in order to avoid limiting or obscuring the present invention. Such descriptions and representations are used by those skilled in the art to describe and convey the substance of their work to others skilled in the art. It is also noted that, throughout this detailed description, certain elements in the figures are illustrated for simplicity and clarity and have not necessarily been drawn to scale. In addition, the dimensions of some of the elements in the figures may be exaggerated relative to other elements to help improve the understanding of the embodiments of the present disclosure. Further, reference numerals have been repeated among the drawings to represent corresponding or analogous elements. In addition, the depicted device layers that are shown as being deposited and/or etched are represented with simplified line drawings, though it will be appreciated that, in reality, the actual contours or dimensions of device layers will be non-linear, such as when the described etch processes are applied at different rates to different materials, or when the described deposition or growth processes generate layers based on the underlaying materials.

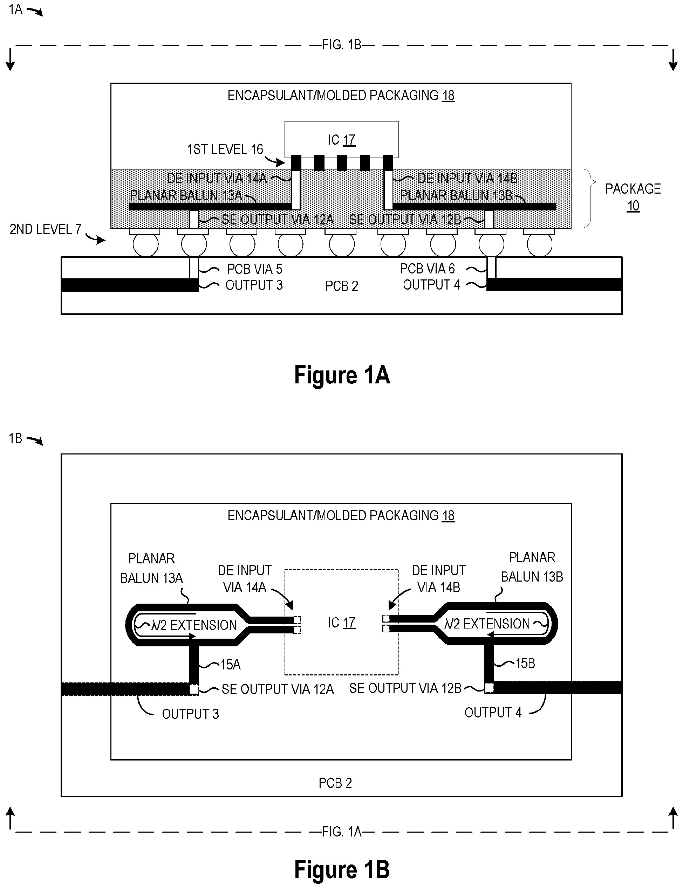

For an improved understanding of selected embodiments of the present disclosure, reference is now made to Figures 1A-1B which depict cross-sectional and plan views of an integrated circuit package assembly 1A, 1B which includes an encapsulated integrated circuit (IC) die or chip 17 which is encapsulated in a molded packaging structures 18 and mounted or attached to a package 10. In particular, Figure 1A depicts a cross-sectional view 1A of the integrated circuit package assembly as seen from the perspective view Fig. 1A shown in Figure 1B, and Figure 1B depicts a plan view 1B of the integrated circuit package assembly as seen from the perspective view Fig. 1B shown in Figure 1A. Implemented as a flip chip package, the integrated circuit package assembly 1A includes first level interconnects 16 connecting the discrete IC die 17 to the package substrate 10, and also includes second level interconnects 7 connecting the package substrate 10 to a printed circuit board 2 for routing to external circuits (not shown). As depicted, the IC die or chip 17 is positioned and attached with face-down conductors for alignment with and connection over the first level interconnects 16 to the embedded face-up conductors in the package substrate 10. For example, the first level interconnects 16 may be implemented with an array of conductive wafer vias, pillars or bumps that are aligned and positioned to make direct electrical connection between the IC chip 17 and the package substrate 10. However, it will be appreciated that IC chip 17 may be positioned and arranged with any suitable configuration of face-down patterned conductors for aligned attachment over the first level interconnects 16 to the top of the package substrate 10.

The depicted package substrate 10 is formed with one or more substrate layers formed with sandwiched layers of insulating material (e.g., glass, silicon, plastic and/or fiberglass) that contains patterned conductive lines and/or via structures for routing signals and power through the package substrate structure 10 to make electrical connection over the second level interconnects 7 on the PCB 2. Though not shown, it will be appreciated that the package substrate 10 may include a stack of redistribution line (RDL) layers formed on the upper surface of the package substrate 10 and/or the bottom surface of the package substrate 10 to provide fine-pitch routing layers which electrically connect circuitry of the IC die 17 to the PCB 2 using the first and second level interconnects 16, 7.

As depicted, the package substrate 10 includes one or more planar baluns 13A, 13B, each formed in a single metal substrate layer 13A, 13B with the winding orientated horizontally to convert differential ended signals from the IC die 17 to a single ended signal at the protruding conductive microstrip linear segment 15A, 15B. The package substrate 10 also includes DE input vias 14A, 14B for connecting the planar baluns 13A, 13B over selected first level interconnects 16 to the IC die 17 which generates the DE input signals. In addition, the package substrate 10 also includes SE output vias 12A, 12B for connecting over selected second level interconnects 7 to the PCB vias 5, 6 for output over the output lines 3, 4 in the printed circuit board 2.

As best seen in Figure 1B, each balun 13A, 13B is constructed with a metal microstrip line (shown in black) having a thickness which may be smaller than its width, and which is formed with a hairpin shape with two elongated conductive microstrip linear segments connected on one end to the differential input via conductors 14A, 14B, and connected together on the opposed end with a conductive microstrip U-shaped segment. Formed in parallel with one another, the elongated conductive microstrip linear segments of each balun 13A, 13B are separated by a first spacing distance. In addition, each balun 13A, 13B also includes a conductive microstrip linear segment 15A, 15B which protrudes orthogonally from one of the elongated conductive microstrip linear segments. As formed, the protruding conductive microstrip linear segment 15A, 15B directly, electrically connects one of the elongated conductive microstrip linear segments to a single ended (SE) via or pin 12A, 12B. Though not shown, it will be appreciated that a co-planar ground metal layer is also formed in the single metal substrate layer of the package substrate 10 to surround (without contacting) each balun 13A, 13B balun and protruding conductive microstrip linear segment 15A, 15B so as to be separated therefrom by a substantially uniform gap or spacing. As depicted, the location of the protruding conductive microstrip linear segment 15A, 15B is shown as being substantially at the center of the elongated conductive microstrip linear segments, but it will be appreciated that the actual intersection location is determined by the wavelength of the intended target operating frequency of the signal being processed by the balun. More specifically, the electrical length of the longer path from the protruding conductive microstrip linear segment 15A, 15B to the differential input via conductors 14A, 14B is a half wavelength longer than the electrical length of the shorter path from the protruding conductive microstrip linear segment 15A, 15B to the other differential input via conductors 14A, 14B.

As seen from the foregoing, the challenge of transforming DE package input signals into SE package output signals using a horizontal balun can increase the package size, and therefore costs for the integrated circuit package assembly 1A, 1B. In particular, the conventional approach for using planar baluns in a single package layer (with ground in the second layer) requires that the lateral extent of the balun must accommodate at least the λ/2 length extension for one of the elongated conductive microstrip linear segments of each balun 13A, 13B, where λ is the wavelength derived from the speed of light divided by frequency of the differential ended signal (e.g., λ = 3.7 millimeters for an 80 gigahertz differential ended signal). The resulting planar baluns are bulky and require a large area in the package.

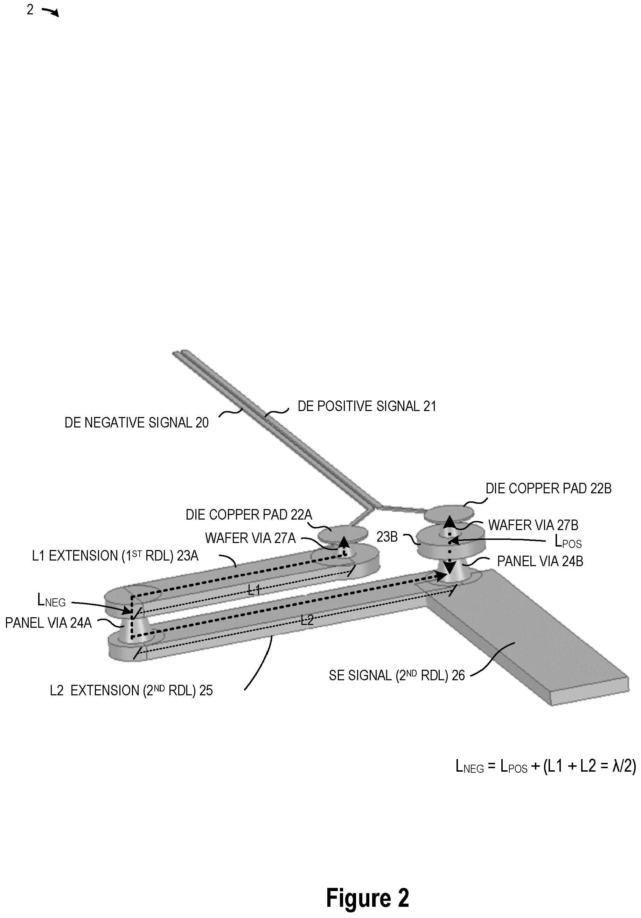

Various illustrative embodiments of the present invention will now be described in detail with reference to Figures 2-5 which depict a compact package balun for implementing a vertical or stacked transformation of the DE signals to SE signals using two layers of package, hence resulting in a compact balun which uses about one-third of the area of the design of a standard planar balun. Although specific example materials, thicknesses, and processes are described herein, those skilled in the art will recognize that other materials, thicknesses, and processes with similar properties or characteristics can be substituted without loss of function. It is noted that, throughout this detailed description, certain layers of materials will be deposited and removed to form the integrated circuit package assembly. Where the specific procedures for processing such layers or thicknesses of such layers are not detailed below, conventional techniques known to one skilled in the art for depositing, removing, forming, or otherwise processing such layers at appropriate thicknesses shall be intended. Such details are well known and not considered necessary to teach one skilled in the art how to make or use the present disclosure.

For an improved understanding of selected embodiments of the present disclosure, reference is now made to Figure 2 which depicts a perspective view of a vertical balun 2 for converting differential-ended die signals to a single-ended signal. In general terms, the vertical balun includes a first non-phase-shifting conductive balun element 27B/23B/24B and a second phase-shifting conductive balun element 27A/23A, 24A, 25 which are connected as shown between the differential-ended signal nodes 20, 21 and the single-ended signal node 26.

As depicted, the vertical balun 2 is connected with die copper pads 22A, 22B to receive separate components of the differential signal from the IC die which arrive on first and second conductive traces or microstrips 20, 21. In selected embodiments, the first conductive trace 20 conveys a DE negative signal input, and the second conductive trace 21 conveys a DE positive signal input. Though not shown, the IC die may include communication circuitry which generates the differential signal at first and second ports which collectively form a differential port for conveying the differential signal. The communication circuitry may represent any suitable receiver circuitry for receiving differential RF signals or any suitable transmitter circuitry for providing differential RF signals for transmission. In an alternative embodiment, the communication circuitry may be configured as transceiver circuitry having a receiver mode for receiving signals and a transmitter mode for transmitting signals. As will be appreciated, the separate components of the differential signal arriving at the conductive microstrips 20, 21 have approximately equal amplitude with a 180-degree phase difference, whether the signal is being input or output by the balun 2. In selected embodiments, the target frequency of operation for the differential signal is within a target bandwidth of 76-81 GHz, and more particularly is approximately 78 GHz.

In addition, the vertical balun 2 includes first and second conductive wafer vias 27A, 27B which are connected, respectively, to the die copper pads 22A, 22B. In selected embodiments, the first and second conductive wafer vias, pillar or bump 27A, 27B may be formed as conductive wafer via structures in patterned openings of a top dielectric layer on the IC die to make direct electrical contact with the die copper pads 22A, 22B. Alternatively, the first and second conductive wafer vias 27A, 27B may be formed as conductive wafer via, pillars or bump structures in patterned openings of a package substrate dielectric layer to make direct electrical contact with the die copper pads 22A, 22B.

In addition, the vertical balun 2 includes first and second patterned conductive layers 23A, 23B which are formed in a first package layer and connected, respectively, to the first and second conductive wafer vias, pillars or bumps 27A, 27B. In selected embodiments, the first patterned conductive layer 23A may be formed as a first patterned length extension (L1 extension) metal layer within a first RDL layer of the package substrate to make direct electrical contact with the first conductive wafer vias, pillars or bumps 27A. In addition, the second patterned conductive layer 23B may be formed as a patterned metal layer within the first package layer to make direct electrical contact with the second patterned conductive layer 23B. In the first package layer, the first patterned conductive layer 23A has a proximate end which is spaced apart from the second patterned conductive layer 23B by a minimum specified separation distance, and the first patterned conductive layer 23A extends laterally a first lateral extension distance L1 in a first horizontal direction to a distal end. As depicted, the shape of the patterned conductive microstrip forming the second patterned conductive layer 23B may be circular, though any suitable shape may be used. In addition, the shape of the patterned conductive microstrip forming the first patterned conductive layer 23A may be a linear segment that extends laterally a first extension distance L1 to its distal end. In selected embodiments, the first and second patterned conductive layers 23A, 23B are both formed with patterned conductive microstrip lines which having a thickness (e.g., 20 µm) which may be smaller than its width, and which are formed in the first RDL layer of the package substrate. As will be appreciated, a patterned co-planar ground metal layer (not shown) may be formed in the first package layer on opposed sides of the first and second patterned conductive layers 23A, 23B. In addition, an additional ground metal layer (not shown) may be located beneath (or above) the first and second patterned conductive layers 23A, 23B to extends up to and beyond the entire length and width of balun 2. Generally, ground currents flow in either or both the ground metal layers, and therefore electromagnetic signals can propagate in a microstrip transmission mode, a co-planar transmission line mode, or a combination of both. It is noted that either of the ground metal layers may be omitted in different configurations.

In addition, the vertical balun 2 includes first and second panel vias 24A, 24B which are connected, respectively, to the distal end of the first patterned conductive layer 23A and the second patterned conductive layer 23B. In selected embodiments, the first and second panel vias 24A, 24B may be formed as conductive via structures in patterned openings of a second package layer, such as a dielectric layer having a predetermined thickness (e.g., 25 µm) in the package substrate.

In addition, the vertical balun 2 includes a third patterned conductive layer 25 which is formed in a second package layer and connected to the first and second panel vias 24A, 24B. In selected embodiments, the third patterned conductive layer 25 may be formed as a second patterned length extension (L2 extension) metal layer within a second RDL layer of the package substrate to make direct electrical contact between the first and second panel vias 24A, 24B. In the second package layer, the second patterned conductive layer 25 has a distal end which extends under the first panel via 24A to make direct electrical contact therewith. In addition, the second patterned conductive layer 23B extends laterally from the distal end in the reverse horizontal direction and over a second lateral extension distance L2 to a proximate end which extends under the second panel via 24B to make direct electrical contact therewith. Again, the shape of the patterned conductive microstrip forming the third patterned conductive layer 25 may be a linear segment that extends laterally over the second extension distance L2>L1. In selected embodiments, the third patterned conductive layer 25 is formed with a patterned conductive microstrip line having a thickness (e.g., 20 µm) which may be smaller than its width, and which is formed in the second RDL layer of the package substrate. As will be appreciated, a patterned co-planar ground metal layer (not shown) may be formed in the second package layer on opposed sides of the third patterned conductive layer 25. In addition, an additional ground metal layer (not shown) may be located beneath (or above) the third patterned conductive layer 25 to extends up to and beyond the entire length and width of balun 2. Generally, ground currents flow in either or both the ground metal layers, and therefore electromagnetic signals can propagate in a microstrip transmission mode, a co-planar transmission line mode, or a combination of both. It is noted that either of the ground metal layers may be omitted in different configurations.

In addition, the vertical balun 2 includes a patterned single-ended signal node layer 26 which is formed in the second package layer to extend orthogonally from the proximate end of the third patterned conductive layer 25. In selected embodiments, the patterned single-ended signal node layer 26 may be integrally formed with the proximate end of the third patterned conductive layer 25 as a patterned metal layer within the second RDL layer of the package substrate to make direct electrical contact with the third patterned conductive layer 25. As will be appreciated, any single ended signal generated at the patterned single-ended signal node layer 26 can be routed or communicated through the package substrate to or from external circuitry using a printed circuit board (not shown).

As disclosed herein, the vertical balun 2 may be formed to transition vertically with any suitable multi-layer package technology, such as a two-layer Panel Level Packaging (2L PLP) device, to provide a compact, stacked design for converting the differential ended signal into a single ended signal. As formed, the collective geometries of the conductive microstrip linear segments 23A, 24A, 25 on the longer balun path distance (e.g., L_{NEG} indicated with the dashed line) provide a stacked, U-shaped segment having a combined horizontal length (e.g., L1 + L2) in multiple stacked substrate layers which is controlled to maintain the half electrical wavelength separation of the distance between the longer balun path distance L_{NEG} and the shorter balun path distance (e.g., L_{POS} indicated with the dotted line) for receiving the differential-ended signals at the target frequency of operation. In equational terms, L_{NEG} = L_{POS} + L1 + L2 = L_{POS} + λ/2, where the wavelength λ is an effective wavelength which refers to the wavelength of the frequency within the substrate material.

In operation, a single-ended signal having a specified operation frequency received at the SE signal node 26 is split by the balun 2 into a differential signal between the first and second die copper pads 22A, 22B, in which the differential signal is conveyed to the first and second conductive traces or microstrips 20, 21 of the mm-wave circuitry. The separate components of the differential signal arriving over the shorter and longer balun paths at the mm-wave circuitry have about equal amplitude with a 180-degree phase difference. In the reverse direction, a differential signal output by the communication circuitry at the specified operation frequency with a 180-degree phase difference at the first and second die copper pads 22A, 22B is combined by the balun 2 into a single-ended signal provided to the SE signal node 26.

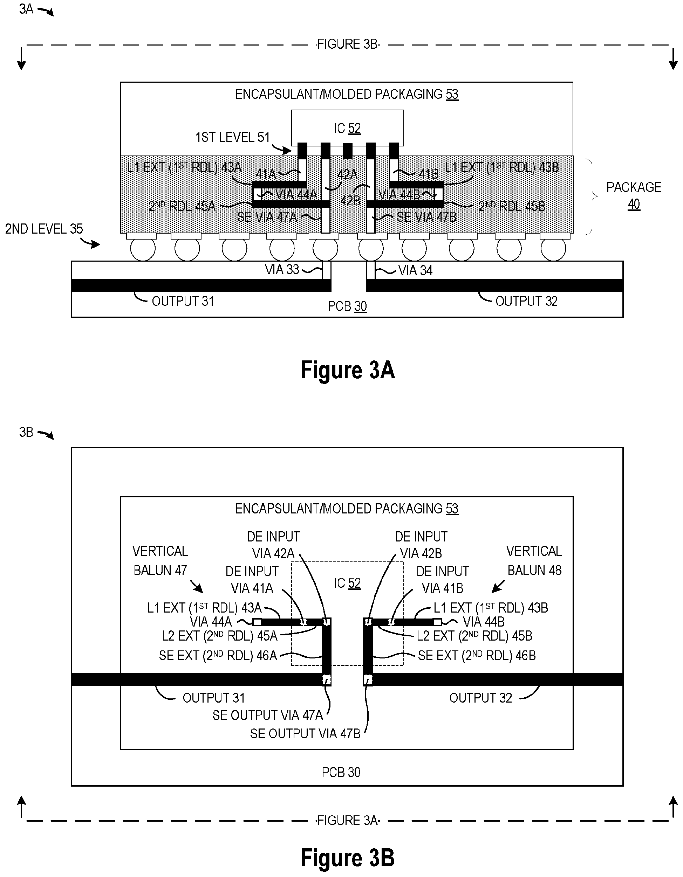

For an improved understanding of selected embodiments of the present disclosure, reference is now made to Figures 3A-3B which depict cross-sectional and plan views of an integrated circuit package assembly 3A, 3B having an encapsulated IC die or chip 52 which is encapsulated in a molded packaging structures 53 and mounted or attached to a package 40. In particular, Figure 3A depicts a cross-sectional view 3A of the integrated circuit package assembly as seen from the perspective view Fig. 3A shown in Figure 3B, and Figure 3B depicts a plan view 3B of the integrated circuit package assembly as seen from the perspective view Fig. 3B shown in Figure 3A. As can be seen, the integrated circuit package assembly 3A, 3B is similar to the integrated circuit package assembly 1A, 1B balun previously described with reference to Figures 1A and 1B except that a vertical or stacked balun 41-47 is formed in the package substate 40 as described more fully hereinbelow.

When implemented as a flip chip package, the integrated circuit package assembly 3A includes first level interconnects 51 connecting the discrete IC die 52 to the package substrate 40, and also includes second level interconnects 35 connecting the package substrate 40 to a printed circuit board 30 for routing to external circuits (not shown). Positioned and attached with face-down conductors, the IC die or chip 52 is aligned for connection over the first level interconnects 51 to the embedded face-up conductors in the package substrate 40. In turn, the package substrate 40 is formed one or more sandwiched dielectric layers and patterned conductive lines and/or via structures for routing signals and power through the package substrate structure 40 to make electrical connection over the second level interconnects 35 to the PCB 30. In selected embodiments, the package substrate 40 may include a stack of redistribution line (RDL) layers formed on the upper and/or bottom surface of the package substrate 40 and/or the bottom surface of the package substrate 40 to provide fine-pitch routing layers which electrically connect circuitry of the IC die 52 to the PCB 30 using the first and second level interconnects 51, 35.

In the disclosed package substrate 40, one or more vertical baluns 41A-47A, 41B-47B are formed in a plurality of stacked metal substrate layers, where each vertical balun includes a shorter balun bath (e.g., 42A) and longer balun path (e.g., 41A, 43A-45A) with a winding orientated vertically to convert differential ended signals from the IC die 52 to a single ended signal node at the protruding conductive microstrip linear segment 46A, 46B. As depicted, the package substrate 40 includes DE input vias 41A/B, 42A/B for connecting the vertical balun segments 43A/B-46A/B over selected first level interconnects 51 to the IC die 52 which generates the DE input signals. In addition, the package substrate 40 includes SE output vias 47A, 47B for connecting over selected second level interconnects 35 to the PCB vias 33, 34 for output over the output lines 31, 32 in the printed circuit board 30.

As best seen in Figure 3A, each vertical balun (e.g., 41A-47A) includes a first non-phase-shifting conductive balun path element (connected between the first differential-ended signal node and the single-ended signal node) and a second phase-shifting conductive balun path element (connected between the second differential-ended signal node and the single-ended signal node). In selected embodiments, the first non-phase-shifting conductive balun path element is formed with one or more vertically stacked conductive layers 42A which extend through the multi-layer package 40 to directly electronically connect the first differential-ended signal node from the IC die 52 and the single-ended signal node segment 46A. In addition, the second phase-shifting conductive balun path element is formed with first and second conductive elements 43, 45 which are aligned in parallel and extend through the multi-layer package 40 to directly electronically connect the second differential-ended signal node from the IC die 52 and the single-ended signal node segment 46A. In a first RDL package layer, the first conductive element 43A, 43B may be constructed with a first elongated microstrip line (shown in black) having a uniform width and thickness is spaced apart from the vertically stacked conductive layer(s) 42A and extends laterally a first extension distance L1 in a first direction to a distal end. In a second RDL package layer, the second conductive element 45A, 45B may be constructed with a second elongated microstrip line (shown in gray) having a uniform width and thickness that is formed in alignment with the first conductive element 43A, 43B and extends laterally a second extension distance L2 in a second, reverse direction from a distal end to make direct electrical contact with the vertically stacked conductive layer(s) 42A. Formed in parallel with one another in different package layers, the first and second conductive elements 43, 44are vertically separated by a first spacing distance. Connected at the distal ends by a panel via structure 44A, 44B, the first and second conductive elements 43, 44, 45 form a U-shaped longer balun path connected on one end to the differential input via conductors 41A, 41B , and connected on the opposed end with a shorter balun path formed with the vertically stacked conductive layer(s) 42A, 42B. Integrally formed at the connection point between the longer and shorter balun paths, the single-ended signal node segment 46A protrudes orthogonally from one of the second conductive elements 45A, 45B, and may be routed through the SE output vias 47A, 47B for connection over selected second level interconnects 35 to the vias 33, 34 of the PCB 30. As will be appreciated, co-planar ground metal layers may also be formed in the multi-layer package 40 to surround (without contacting) each conductive element in the vertical balun.

In operation, the vertical balun disclosed herein is operatively configured to convert balanced differential signals into an unbalanced single ended signal and to transform the impedance between the differential signal Z_{DE} (from the die) and the single ended signal Z_{SE} for maximum power transfer. To this end, the vertical balun splits the differential ended signal from the IC die into a longer balun path (e.g., L_{NEG} shown in Figure 2) and a shorter balun path (e.g., L_{POS}), where the length of the longer balun path L_{NEG} has an additional length of an electrical wavelength λ/2 = L1 + L2 to compensate for the 180°-phase difference in the differential ended signal. By extending the line length of the longer balun path line by an electrical wavelength λ/2, the two balanced signals add in phase. As a result, the differential signal impedance Z_{DE} of the shorter balun path L_{POS} and the longer balun path L_{NEG} (Z_{L_{POS}/L_{NEG}}) is then transformed into single ended signal impedance (Z_{SE}) according to the equation Z_{SE} ≈ Z_{L_{POS}/L_{NEG}}/2. To assess the impedance transformation, the impedance matching of the vertical balun at the input and at the output of the signal is assessed with the insertion loss from the DE signal input to the SE signal output. In addition, the common mode rejection (CMR) ratio is used to assess the conversion of balanced DE signal input to the SE signal output.

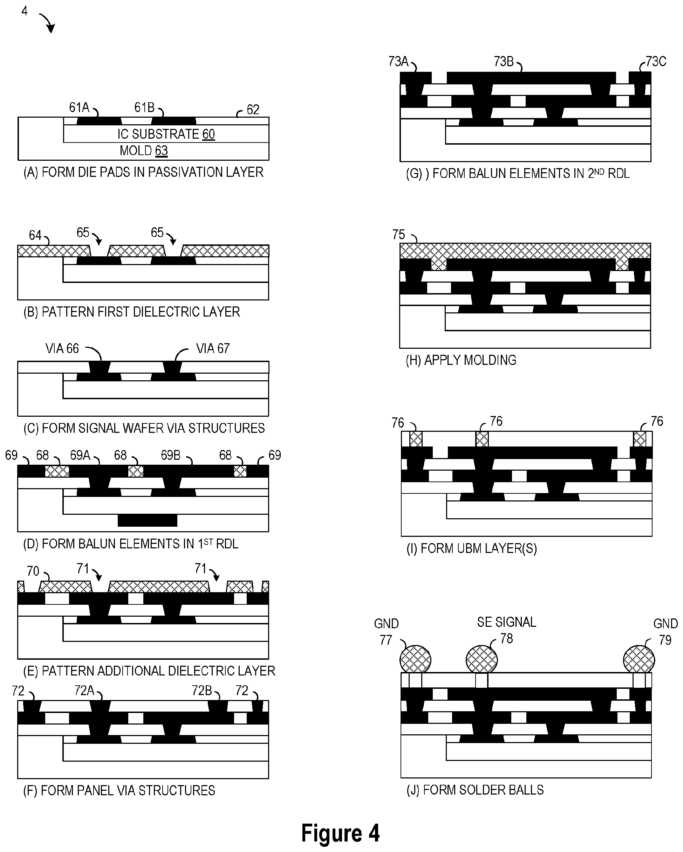

For an improved understanding of selected embodiments of the present disclosure, reference is now made to Figure 4 which illustrates cross-sectional views 4 for a fabrication sequence for forming a packaged integrated circuit assembly with an integrated vertical balun formed in multiple levels of a package substrate. In the ensuing description of the fabrication stages, newly added features at each stage are identified with cross-hatched shading and additive reference numbers without retaining the previously listed reference numbers. While the disclosed sequence of packaged integrated circuit assembly fabrication stages are shown as forming a 2L PLP package having two levels of redistribution lines (RDL) connecting a die pad to a solder ball external conductor, it will be appreciated that addition or fewer RDLs levels can be formed and/or that other external conductors can be used, such as copper pillars or bumps.

In a first stage (A) of the disclosed embodiment, an integrated circuit substrate 60 is provided with one or more die pads 61A, 61B formed on either side of the IC substrate 60 which may be a silicon substrate layer on a backside or frontside of the IC die, or may be a passivation layer or interconnect layer formed on a backside or frontside of the IC die. Either before or after forming the die pad(s) 61A/B, a passivation layer 62 is formed on the IC substrate 60, such as by depositing and polishing one or more suitable dielectric layers to leave one or more exposed contact regions of the die pad(s) 61A/B. Subsequently, a molded packaging structure 63 is formed to encapsulate the backside of the IC substrate 60.

At a second stage (B), a first patterned dielectric layer 64 is formed over the IC substrate, such as by spin-coating or depositing one or more dielectric material layers to a predetermined thickness or height (e.g., 25 µm), and then using any suitable selective etch process to sequentially pattern, etch, and/or develop the dielectric material layer(s) to define wafer via openings 65 which expose the underlying die pad(s) 61A/B.

At a third stage (C), the conductive wafer via structures 66, 67 are formed in the wafer via openings 65 of the first patterned dielectric layer 64 to contact the underlying die pad(s) 61A/B. For example, the conductive wafer via structures 66, 67 may be formed by depositing one or more conductive layers over the IC substrate to fill the wafer via openings 65, and then polishing, etching, or otherwise planarizing the conductive layer(s) to form the first and second conductive wafer via structure 66, 67. As formed, the first conductive wafer via structure 66 is electrically connected to a first differential ended signal provided by the die pad 61A, and the second conductive wafer via structure 67 is electrically connected to a second differential ended signal provided by the die pad 61B.

At a fourth stage (D), a first set of conductive balun path elements 69 is formed as a patterned first redistribution layer (RDL) in a second patterned dielectric layer 68 to contact at least the underlying conductive wafer via structures 66, 67. For example, the second patterned dielectric layer 68 may be formed by spin-coating or depositing one or more dielectric material layers to a predetermined thickness or height (e.g., 20 µm), and then using any suitable selective etch process to sequentially pattern, etch, and/or develop the dielectric material layer(s) to define via openings which expose the underlying conductive wafer via structures 66, 67. Subsequently, one or more conductive layers may be deposited over the IC substrate to fill the via openings in the second patterned dielectric layer 68 and then polished, etched, or otherwise planarized (e.g., chemical mechanical polish) to form the first set of conductive balun path elements 69. Alternatively, the first set of conductive balun path elements 69 may be formed as a patterned first RDL by sputter depositing a seed layer over the second patterned dielectric layer 68, forming a patterned photoresist mask with mask openings which overlap with the conductive wafer via structures 66, 67, electroplating one or more conformal conductive layers to fill the mask openings, stripping the patterned photoresist mask, and then etching the exposed seed layer from the surface of the second patterned dielectric layer 68 to define the first set of conductive balun path elements 69. As formed, the first set of conductive balun path elements 69 includes a first conductive layer 69A that is electrically connected over the conductive wafer via structure 66 to the first differential ended signal provided by the die pad 61A. In addition, the first set of conductive balun path elements 69 includes a second conductive layer 69B that is electrically connected over the second conductive wafer via structure 67 to the second differential ended signal provided by the die pad 61B.

At a fifth stage (E), an additional patterned dielectric layer 70 is formed over the IC substrate to define panel via openings 71 which expose the underlying first set of conductive balun path elements 69. For example, the additional patterned dielectric layer 70 may be formed by spin-coating or depositing one or more dielectric material layers to a predetermined thickness or height (e.g., 35 µm), and then using any suitable selective etch process to sequentially pattern, etch, and/or develop the dielectric material layer(s) to define panel via openings 71.

At a sixth stage (F), the conductive panel via structures 72 are formed in the panel via openings 71 of the additional patterned dielectric layer 70 to contact the underlying conductive balun path elements 69. For example, the conductive panel via structures 72 may be formed by depositing one or more conductive layers over the IC substrate to fill the panel via openings 71, and then polishing, etching, or otherwise planarizing the conductive layer(s) to simultaneously form the first and second conductive panel via structure 72A, 72B. As formed, the first conductive panel via structure 72A is electrically connected over the first conductive layer 69A and first conductive wafer via structure 66 to the first differential ended signal provided by the die pad 61A. In addition, the second conductive panel via structure 72B is electrically connected over the second conductive layer 69B and second conductive wafer via structure 67 to the second differential ended signal provided by the die pad 61B.

At a seventh stage (G), a second set of conductive balun path elements 73 is formed as a patterned second RDL to contact at least the underlying first and second conductive panel via structure 72A, 72B. For example, the second set of conductive balun path elements 73 may be formed by depositing one or more conductive layers over the IC substrate to a predetermined thickness or height (e.g., 20 µm), and then a suitable selective etch process may be applied to sequentially pattern and etch the conductive layer(s) to define the second set of conductive balun path elements 73A-C. Alternatively, the second set of conductive balun path elements 73 may be formed as a patterned second RDL by sputter depositing a seed layer over the IC substrate, forming a patterned photoresist mask with mask openings which overlap with the intended location of the second set of conductive balun path elements 73, electroplating one or more conformal conductive layers to fill the mask openings, stripping the patterned photoresist mask, and then etching the exposed seed layer to define the second set of conductive balun path elements 73. As formed, the second set of conductive balun path elements 73 includes a third conductive layer 73B that electrically connects the conductive panel via structures 72A, 72B, thereby coupling the first and second differential ended signals provided by the die pads 61A, 61B to a shared node around a loop formed with a vertically stacked segment 61A/66/69A/72A and a U-shaped segment 61B/67/69B/72B/73B. Though not shown in the cross-sectional view of Figure 4, the second set of conductive balun path elements 73 formed in the patterned second RDL also includes a single-ended signal node layer which extends orthogonally to the longitudinal direction of the third conductive layer 73B and which is vertically aligned with the first conductive wafer via structure 66.

As disclosed herein, the fabrication stages (A)-(G) may be repeated one or more additional times to create additional balun path elements in other package layers if desired. As disclosed herein, the vertical balun may be designed in the first and second RDLs as part of a 2L-PLP package; however, the vertical balun can be designed in any other suitable package stack-up. For example, in a four-layer FCCSP package stack-up, the vertical balun can be designed in the second and third metal layers (M2 and M3) of the package, and the top metal layer (M4) and bottom metal layer (M1) can be sued to form ground plane layers for the balun signal lines in M2 and M3. Such vertical shielding will allow a better return path for the differential signals and hence will result in better common mode rejection, which is an essential figure of merit for characterizing the baluns. In addition, the height increase between the M2 and M3 layers can also be used to better optimize the RF performance. Thus, the vertical balun can be designed to exploit the different stacks-up rules for example staggered via's, micro via pad dimensions, and different layer heights to achieve the optimum RF performance, especially for common mode rejection ratio. In addition, the vertical balun can be designed with multiple layers, so that the vertical height of the stack-up can be used and the vertical balun can be further miniaturized, which will result in a smaller package and lower cost.

At some point, an external conductor may be formed in electrical contact with the balun path elements. For example, at an eighth stage (H), a mold layer 75 is applied or formed to completely cover the second set of conductive balun path elements 73, thereby forming an encapsulant or molding compound body 75 that encapsulates the package substrate. For example, the molding material can be any appropriate encapsulant having properties that are suitable for providing mechanical support and structural integrity to maintain the physical arrangement of the package substrate and IC substrate. For example, the molding 75 may use silica-filled epoxy molding compounds, plastic encapsulation resins, and other polymeric materials such as silicones, polyimides, phenolics, and polyurethanes. The molding 75 can be applied by a variety of standard processing techniques used in encapsulation including, for example, printing, pressure molding, injection molding, film-assisted molding, and spin application. Once the molding material is applied, the panel can be cured by exposing the materials to certain temperatures for a period of time, or by applying curing agents, or both. In addition, a grind or etch process may be applied to planarize the mold layer 75 to achieve a desired panel thickness.

At a ninth stage (I), under bump metallization (UBM) structures 76 are formed in the mold layer 75 in contact with at least the third conductive layer 73B. For example, a controlled laser etch may be applied to form UBM openings in the mold layer 75 which exposes the underlying third conductive layers 73. In the UBM openings, the UBM structures 76 may be formed by sputter depositing a seed layer over mold layer 75, forming a patterned photoresist mask with mask openings which overlap with the UBM openings, electroplating one or more conformal conductive layers in the UBM openings, stripping the patterned photoresist mask, and then etching the exposed seed layer from the surface of the mold layer 75 to define the UBM structures 76.

At a tenth stage (J), solder ball connectors 77-79 are formed using any suitable bump flow. For example, the solder ball connectors 77-79 may be formed by forming a patterned photoresist mask with a contact opening which exposes the underlying UBM structures 76, electroplating a solder layer in the contact opening, stripping the patterned photoresist mask, and then reflowing the solder layer to define the solder ball connectors 77-79. As will be appreciated, there are alternatives to forming solder ball connectors 77-79, such as forming copper pillar structures on the UBM structures 76.

As described hereinabove, a first sequence of fabrication processing steps are used to form the multi-layer package with a vertical balun and surrounding ground planes, starting with the formation of the fabrication of the first and second die pads 61A, 61B on the IC substrate (stage 4(A)) where the differential ended signals are generated from the power amplifier output of the transmitter or provided to the low noise amplifier inputs of the receiver. Next, the multi-layer package processing steps connect the differential signals from the die pads 61A, 61B to a first package layer (e.g., RDL1) using the wafer vias 66, 67 and the patterned conductive ground layers 69 and balun layers 69A, 69B (stages 4(B)-(D)). Next, the multi-layer package processing steps connect the differential signals from the patterned conductive balun layers 69A, 69B to the second package layer (e.g., RDL2) using the panel vias 72A, 72B and the patterned conductive ground layers 73A, 73B and balun layer 73B (stages 4(E)-(G)). As formed, a first differential signal (e.g., DE+) proceeds directly through the vertical balun along a shorter linear balun path between RDL1 and RDL2 using the panel via 72A. However, the second differential signal (e.g., DE-) proceeds through the vertical balun along a longer U-shaped balun path between RDL1 and RDL2 using the patterned conductive balun layer 69B, panel via 72B, and patterned conductive balun layer 73B. In particular, the second differential signal traces in the first package layer RDL1 along the patterned conductive balun layer 69B in a lateral direction for a certain length (~λ/4), transitions between the first and second package layers (RDL1 to RDL2) using the panel via 72B, and then traces back in the second package layer RDL2 along the patterned conductive balun layer 73B in the reverse lateral direction for a certain length (~λ/4) until reaching the first differential signal line. At the connection point between the first and second differential signals, a single ended signal is traced out in a patterned single-ended signal node layer which is formed in the second package layer RDL2 to extend orthogonally from the patterned conductive balun layer 73B, as the SE output of the balun. If the electrical length of the second differential signal from RDL1 to RDL2 is equivalent to λ/2, then the first and second differential signals will add in phase and the differential ended signal will convert into the single ended signal. As shown, the patterned conductive ground layers 69, 73A, 73C and connecting panel vias 72 are positioned on opposed sides of the vertical balun elements. In addition, conductive ground layers will be formed on each lateral side of the patterned conductive balun layer 69B and the patterned conductive layer 73B which extend in the same lateral direction because to form coplanar waveguide (CPW) transmission lines. For a microstrip mode to run through a transmission line, the patterned conductive ground layers should be as close as possible to the balun signal lines.

In addition, a second sequence of fabrication processing steps are used to route the single ended signal to/from the vertical balun through the multi-layer package to the second level interconnects for connection to the printed circuit board conductors, starting with forming or applying a package molding 75 (stage 4(H)) to cover the multi-layer package. Next, the multi-layer package processing steps form the UBM structures 76 in the package molding (stage 4(I)) which are located to be directly, electrically connected to the vertical balun and conductive ground layers. Subsequently, the multi-layer package processing steps form the solder ball connectors 77-79 which are located to be directly, electrically connected to the UBM structures 76. In particular, the ground solder ball connectors 77, 79 are connected to the ground layers, and the SE signal solder ball 78 is connected to the patterned single-ended signal node layer formed in the second package layer RDL2.

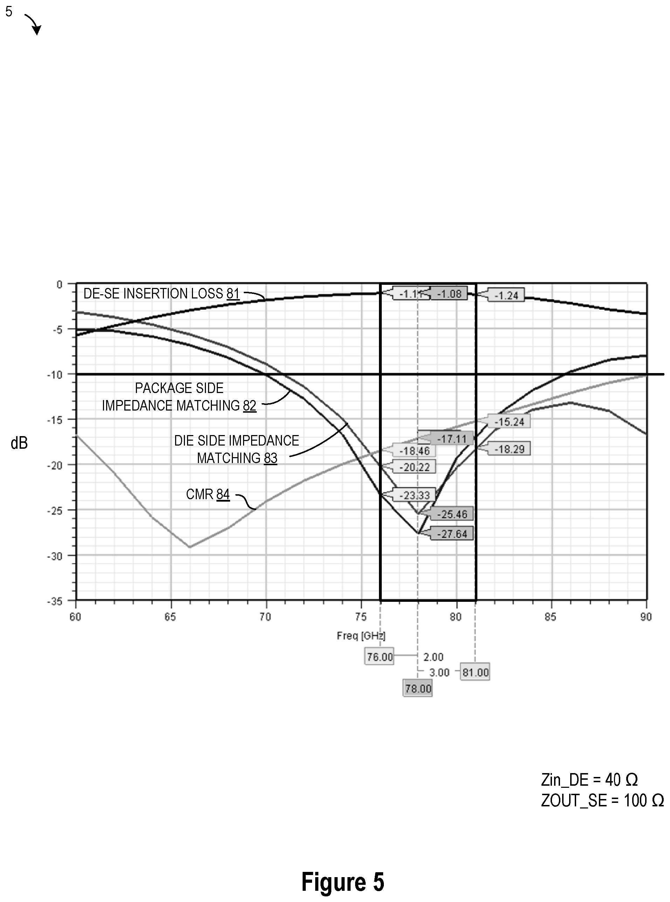

Referring now to Figure 5, there are depicted simulated waveforms 5 of selected RF performance parameters for the vertical balun in a 2L-PLP package in accordance with selected embodiments of the present disclosure. In the simulation, the input impedance on the die side is assumed to be 40Ω, and the output impedance presented by the vertical balun at the package side is set to be 100Ω. The transition from SE output of the vertical balun to the first metal layer of the PCB can then be designed to translate to 50Ω at the PCB side for the customer antenna applications.

The first simulated RF performance parameter is the insertion loss waveform 81 which characterizes the insertion loss of the signal when converted from DE to SE by the vertical balun. As depicted, an acceptable amount of insertion loss of around 1dB can be achieved within the band of 76-81GHz with VB in 2L PLP package

The simulated RF performance parameters also include the package side impedance matching waveform 82 and the die side impedance matching waveform 83 which characterize the impedance matching performance of the vertical balun. As depicted, the vertical balun has a wide bandwidth with very good impedance matching (e.g., more than - 15dB matching) within the frequency band of interest (namely 76-81GHz).

In addition, the common-mode rejection ratio (CMRR) waveform 84 shows that a CMRR value of below -15dB can be achieved with vertical balun. As will be appreciated, the CMRR performance parameter can be improved further by improving the length matching of the SE arm of vertical balun.

By now, it should be appreciated that there has been provided a compact vertical balun formed in a multi-layer panel level package substrate for converting between single-ended and differential-ended signals and associated method of fabrication. As disclosed, the compact vertical balun includes a first non-phase-shifting conductive balun path element having one or more vertically aligned conductive structures formed in at least two package layers and connected between a first differential-ended signal balun node and a single-ended signal balun node. In addition, the disclosed compact vertical balun includes a second phase-shifting conductive balun path element having a plurality of conductive structures formed in at least two package layers and connected between a second differential-ended signal balun node and the single-ended signal balun node. The disclosed compact vertical balun also includes a single-ended contact element integrally formed with the single-ended signal balun node at a package layer location where the first non-phase-shifting conductive balun path element is directly, electrically connected to the second phase-shifting conductive balun path element. In selected embodiments, the single-ended contact element includes a third conductive structure formed in the second package layer as a third linear segment extending orthogonally from the second proximate end of the second conductive structure to form the single-ended signal balun node. In selected embodiments, the second phase-shifting conductive balun path element includes a first conductive structure formed in a first package layer as a first linear segment extending over a first lateral distance from a first proximate end to a first distal end. In addition, the second phase-shifting conductive balun path element includes a second conductive structure formed in a second package layer as a second linear segment extending over a second lateral distance from a second proximate end to a second distal end. As disclosed, the first and second linear segments are aligned in parallel and are connected together by a conductive via structure connecting the first and second distal ends of the first and second linear segments to extend vertically through the multi-layer package. In selected embodiments, a sum of the first and second lateral distances is substantially equal to one-half of an electrical wavelength for an intended operation frequency of the differential-ended signal. In selected embodiments, the first non-phase-shifting conductive balun path element and the second phase-shifting conductive balun path element are connected and configured to split a single-ended signal having a specified operation frequency received at the single-ended signal balun node into first and second differential signals at the first and second differential-ended signal balun nodes having about equal amplitude with a 180-degree phase difference. In other selected embodiments, the first non-phase-shifting conductive balun path element and the second phase-shifting conductive balun path element are connected and configured to combine a differential signal having a specified operation frequency received at the first and second differential-ended signal balun nodes with a 180-degree phase difference into a single-ended signal at the single-ended signal balun node. In selected embodiments, the compact vertical balun may also include one or more first coplanar ground metal layers which substantially surround the first conductive structure in the first package layer and which are separated laterally from the first conductive structure by a uniform gap, and one or more second coplanar ground metal layers which substantially surround the second conductive structure in the second package layer and which are separated laterally from the second conductive structure by a uniform gap. In selected embodiments ,the compact vertical balun may be formed in a multi-layer panel level package substrate which is selected from the group consisting of a two-layer panel level package (2L PLP), a multi-layer flip chip chip scale package (FCCSP), a fan-out wafer level package (FOWLP), a launcher-in-package (LiP), or a substrate-based package.

In another form, there has been provided an integrated circuit package and associated method of fabrication. As disclosed, the integrated circuit package includes a multi-layer package (e.g., a multi-layer panel level package) with a vertical balun. As formed, the vertical balun includes one or more vertically aligned conductive structures formed in at least two layers of the multi-layer package and connected between a first differential-ended signal balun node and a single-ended signal balun node in the multi-layer package. In addition, the vertical balun includes a plurality of conductive structures formed in at least two layers of the multi-layer package to form a vertically stacked U-shaped path that is connected between a second differential-ended signal balun node and the single-ended signal balun node. In selected embodiments, the plurality of conductive structures includes a first conductive structure formed in a first layer of the multi-layer package as a first linear segment extending over a first lateral distance from a first proximate end to a first distal end. In addition, the plurality of conductive structures includes a second conductive structure formed in a second layer of the multi-layer package as a second linear segment which is aligned in parallel with the first linear segment and extends over a second lateral distance from a second proximate end to a second distal end. The plurality of conductive structures also includes a conductive via structure formed in the multi-layer package to electrically connect the first and second distal ends of the first and second linear segments. In selected embodiments, the sum of the first and second lateral distances is substantially equal to one-half of an electrical wavelength for an intended operation frequency of a differential-ended signal that is supplied to the first and second differential-ended signal balun nodes. The vertical balun also includes a single-ended contact conductively coupled at the single-ended signal balun node. In selected embodiments, integrated circuit package may also include an antenna electrically coupled to the single-ended contact, and an integrated circuit (IC) die mounted to the multi-layer package and having first and second electrical ports coupled to the first and second differential-ended signal balun nodes, respectively, wherein the IC die communicates with an external network via the antenna and the vertical balun. In selected embodiments, the IC die includes receiver circuitry, and the vertical balun is configured to split a single-ended signal having a specified operation frequency received by the antenna into first and second differential signals at the first and second electrical ports of the receiver circuitry, wherein the first and second differential signals have about equal amplitude and a 180-degree phase difference. In other selected embodiments, the IC die includes transmitter circuitry, and the vertical balun is configured to combine a differential signal provided by the transmitter circuitry at a specified operation frequency and with a 180-degree phase difference into a single-ended signal for transmission by the antenna. In selected embodiments, the integrated circuit package may also include one or more first coplanar ground metal layers which substantially surround the one or more vertically aligned conductive structures in the multi-layer package and which are separated laterally from the one or more vertically aligned conductive structures by a uniform gap. In addition, the integrated circuit package may also include one or more second coplanar ground metal layers which substantially surround the plurality of conductive structures in the multi-layer package and which are separated laterally from the plurality of conductive structures by a uniform gap. In other selected embodiments, the integrated circuit package may also include a printed circuit board attached to a first surface of the multi-layer package, and an integrated circuit (IC) die mounted to a second surface the multi-layer package.

In yet another form, there has been provided a packaged integrated circuit assembly and associated method of fabrication. As disclosed, the method includes providing an integrated circuit die having first and second differential-ended signal die pads. In addition, the disclosed method includes forming, on the integrated circuit die, a multi-layer package with a vertical balun formed between bottom and top surfaces of the multi-layer package to electrically connect the first and second differential-ended signal die pads to a single-ended signal line. As formed, the vertical balun includes a first non-phase-shifting conductive balun path comprising one or more vertically aligned conductive structures formed in at least two package layers and connected between the first differential-ended signal die pad and the single-ended signal line. In addition, the vertical balun includes a second phase-shifting conductive balun path comprising a plurality of conductive structures formed in at least two package layers and connected between the second differential-ended signal die pad and the single-ended signal line. The disclosed method also includes attaching, to the top surface of the multi-layer package, a first solder ball connector in direct electrical contact with the single-ended signal line. In addition, the disclosed method includes attaching the first solder ball connector to a circuit board. In selected embodiments, the multi-layer package is formed by forming a first redistribution line stack on the integrated circuit die, and then forming a second redistribution line stack on the first redistribution line stack. As formed, the first redistribution line stack includes a first conductive structure vertically aligned with the first differential-ended signal die pad, and a second conductive structure overlapping with the second differential-ended signal die pad and extending over a first lateral distance from a first proximate end to a first distal end. In addition, the second redistribution line stack includes a third conductive structure vertically aligned with the first differential-ended signal die pad, and a fourth conductive structure aligned in parallel with the second conductive structure and extending over a second lateral distance from a second proximate end to a second distal end. As formed, the second and fourth conductive structures are connected together by a conductive via structure connecting the first and second distal ends of the second and fourth conductive structures.

Although the described exemplary embodiments disclosed herein are directed to various IC package assembly structures and methods for making the same, the present invention is not necessarily limited to the example embodiments which illustrate inventive aspects of the present invention that are applicable to a wide variety of processes and/or devices. Thus, the particular embodiments disclosed above are illustrative only and should not be taken as limitations upon the present invention, as the invention may be modified and practiced in different but equivalent manners apparent to those skilled in the art having the benefit of the teachings herein. Accordingly, the foregoing description is not intended to limit the invention to the particular form set forth, but on the contrary, is intended to cover such alternatives, modifications and equivalents as may be included within the scope of the invention as defined by the appended claims so that those skilled in the art should understand that they can make various changes, substitutions and alterations without departing from the scope of the invention in its broadest form.

Benefits, other advantages, and solutions to problems have been described above with regard to specific embodiments. However, the benefits, advantages, solutions to problems, and any element(s) that may cause any benefit, advantage, or solution to occur or become more pronounced are not to be construed as a critical, required, or essential feature or element of any or all the claims. As used herein, the terms "comprises," "comprising," or any other variation thereof, are intended to cover a non-exclusive inclusion, such that a process, method, article, or apparatus that comprises a list of elements does not include only those elements but may include other elements not expressly listed or inherent to such process, method, article, or apparatus.

## Claims

1. A compact vertical balun formed in a multi-layer panel level package substrate for converting between single-ended and differential-ended signals, comprising:
a first non-phase-shifting conductive balun path element comprising one or more vertically aligned conductive structures formed in at least two package layers and connected between a first differential-ended signal balun node and a single-ended signal balun node,
a second phase-shifting conductive balun path element comprising a plurality of conductive structures formed in at least two package layers and connected between a second differential-ended signal balun node and the single-ended signal balun node, and
a single-ended contact element integrally formed with the single-ended signal balun node at a package layer location where the first non-phase-shifting conductive balun path element is directly, electrically connected to the second phase-shifting conductive balun path element.

2. The compact vertical balun of claim 1, where the second phase-shifting conductive balun path element comprises:
a first conductive structure formed in a first package layer as a first linear segment extending over a first lateral distance from a first proximate end to a first distal end, and
a second conductive structure formed in a second package layer as a second linear segment extending over a second lateral distance from a second proximate end to a second distal end,
where the first and second linear segments are aligned in parallel and are connected together by a conductive via structure connecting the first and second distal ends of the first and second linear segments to extend vertically through the multi-layer package.

3. The compact vertical balun of claim 2, where a sum of the first and second lateral distances is substantially equal to one-half of an electrical wavelength for an intended operation frequency of the differential-ended signal.

4. The compact vertical balun of claim 2 or 3, wherein the first non-phase-shifting conductive balun path element and the second phase-shifting conductive balun path element are connected and configured to split a single-ended signal having a specified operation frequency received at the single-ended signal balun node into first and second differential signals at the first and second differential-ended signal balun nodes having about equal amplitude with a 180-degree phase difference.

5. The compact vertical balun of any of claims 2 to 4, wherein the first non-phase-shifting conductive balun path element and the second phase-shifting conductive balun path element are connected and configured to combine a differential signal having a specified operation frequency received at the first and second differential-ended signal balun nodes with a 180-degree phase difference into a single-ended signal at the single-ended signal balun node.

6. The compact vertical balun of any of claims 2 to 5, where the single-ended contact element comprises a third conductive structure formed in the second package layer as a third linear segment extending orthogonally from the second proximate end of the second conductive structure to form the single-ended signal balun node.

7. The compact vertical balun of any of claims 2 to 6, further comprising a third conductive structure formed in the second package layer as a third linear segment extending orthogonally from the second proximate end of the second conductive structure to form the single-ended signal balun node.

8. The compact vertical balun of any preceding claim, further comprising:
one or more first coplanar ground metal layers which substantially surround the first conductive structure in the first package layer and which are separated laterally from the first conductive structure by a uniform gap, and
one or more second coplanar ground metal layers which substantially surround the second conductive structure in the second package layer and which are separated laterally from the second conductive structure by a uniform gap.

9. The compact vertical balun of any preceding claim, where the multi-layer panel level package substrate is selected from the group consisting of a two-layer panel level package, 2L PLP, a multi-layer flip chip chip scale package, FCCSP, a fan-out wafer level package, FOWLP, a launcher-in-package, LiP, or a substrate-based package.

10. An integrated circuit package, comprising:
a multi-layer package; and
a vertical balun formed in the multi-layer package, where the vertical balun comprises:
one or more vertically aligned conductive structures formed in at least two layers of the multi-layer package and connected between a first differential-ended signal balun node and a single-ended signal balun node;
a plurality of conductive structures formed in at least two layers of the multi-layer package to form a vertically stacked U-shaped path that is connected between a second differential-ended signal balun node and the single-ended signal balun node; and
a single-ended contact conductively coupled at the single-ended signal balun node.

11. The integrated circuit package of claim 10, where the plurality of conductive structures comprises:
a first conductive structure formed in a first layer of the multi-layer package as a first linear segment extending over a first lateral distance from a first proximate end to a first distal end;
a second conductive structure formed in a second layer of the multi-layer package as a second linear segment which is aligned in parallel with the first linear segment and extends over a second lateral distance from a second proximate end to a second distal end; and
a conductive via structure formed in the multi-layer package to electrically connect the first and second distal ends of the first and second linear segments.

12. The integrated circuit package of claim 11, where a sum of the first and second lateral distances is substantially equal to one-half of an electrical wavelength for an intended operation frequency of a differential-ended signal that is supplied to the first and second differential-ended signal balun nodes.

13. The integrated circuit package of any of claims 10 to 12, further comprising:
an antenna electrically coupled to the single-ended contact; and
an integrated circuit, IC, die mounted to the multi-layer package and having first and second electrical ports coupled to the first and second differential-ended signal balun nodes, respectively, wherein the IC die communicates with an external network via the antenna and the vertical balun.

14. The integrated circuit package of claim 13, wherein the IC die comprises receiver circuitry, wherein the vertical balun is configured to split a single-ended signal having a specified operation frequency received by the antenna into first and second differential signals at the first and second electrical ports of the receiver circuitry, and wherein the first and second differential signals have about equal amplitude and a 180-degree phase difference.

15. The integrated circuit package of claim 13 or 14, wherein the IC die comprises transmitter circuitry, and wherein the vertical balun is configured to combine a differential signal provided by the transmitter circuitry at a specified operation frequency and with a 180-degree phase difference into a single-ended signal for transmission by the antenna.
